# EUROPEAN PATENT APPLICATION

(11) **EP 4 818 730 A2**
(43) Date of publication of application: **07.10.2026**
(21) Application number: 26166208.4
(22) Date of filing: 19.03.2026
(51) Int. Cl.: G01R 33/3815, G01R 33/54, H01F 6/00

(54) **SUPERCONDUCTING COIL DEVICE, MAGNETIC RESONANCE IMAGING APPARATUS INCLUDING THE SAME, AND TEMPERATURE MANAGEMENT METHOD OF SUPERCONDUCTING COIL DEVICE**

(30) Priority: 31.03.2025 JP 2025059392
(71) Applicant: FUJIFILM Corporation, Tokyo 106-8620 (JP)
(72) Inventor: HOMMA, Yoshitaka, Tokyo, 106-8620 (JP)
(74) Representative: Dehns Germany Partnerschaft mbB

(57) **Abstract**

An object of the present invention is to estimate, from a cooling performance of a cryocooler in a normal state, whether the cryocooler has cooling performance that enables re-excitation, thereby improving rapidity and reliability of preventing a quench from occurring, and even in a state in which refrigeration performance of the cryocooler is deteriorated in an imaging apparatus such as an MRI apparatus is reduced, to prevent a quench from occurring in advance, and to shorten a time until re-driving and re-imaging.

A superconducting coil device includes a superconducting coil housed in a container, at least one cryocooler that is thermally connected to the superconducting coil and cools the superconducting coil, and a processor that inputs temperature information of the superconducting coil detected by a temperature sensor installed in the container and issues a notification to a user. The processor stores a temperature equal to or lower than an excitation-allowable temperature at which excitation of the superconducting coil is allowable as an excitation warning temperature, and issues notification information such as information on cryocooler replacement in a case in which the temperature of the superconducting coil detected by the temperature sensor exceeds the excitation warning temperature for a predetermined time or longer.

## Description

### CROSS-REFERENCE TO RELATED APPLICATIONS

The present application claims priority under 35 U.S.C. § 119 to Japanese Patent Application No. 2025-059392, filed March 31, 2025. Each of the above application(s) is hereby expressly incorporated by reference, in its entirety, into the present application.

### BACKGROUND OF THE INVENTION

### 1. Field of the Invention

The present invention relates to a superconducting coil device, and particularly to a helium-saving superconducting coil device that cools a superconducting coil without filling a container housing the superconducting coil with helium and a temperature management method thereof. Further, the present invention relates to a magnetic resonance imaging (hereinafter, referred to as MRI) apparatus including a superconducting coil device.

### 2. Description of the Related Art

A superconducting coil device is widely used as a static magnetic field generation device such as an MRI apparatus. The superconducting coil device is classified, depending on a cooling method, into a type in which a container housing a superconducting coil is filled with liquid helium to maintain a superconducting state of the coil and a type (a helium-saving device) in which the use of helium is zero or reduced. The latter is further classified into a type (a helium-free type) in which a cryocooler is connected to the superconducting coil via a heat transfer member and a low temperature at which the coil is in a superconducting state is maintained by leads from the cryocooler, a type that uses gaseous helium and cools the coil by heat conduction through a pipe, and a type that cools the coil by heat conduction through a pipe of liquid or gaseous helium.

In any of the superconducting coil devices, a cryocooler is used to maintain a temperature in a container or a temperature of the superconducting coil, but since the performance of the cryocooler deteriorates with the passage of time, temperature management in the container is performed to monitor the performance of the cryocooler and to manage a replacement time of the cryocooler (JP2015-061993A, JP2013-144099A, and the like). For example, JP2015-061993A proposes a system that monitors a temperature and pressure of a system that cools a superconducting coil used as a coil for generating a static magnetic field of an MRI apparatus using liquid helium.

In the helium-saving type superconducting coil in which the container is not filled with liquid helium, since there is no heat capacity provided by helium, a decrease in cooling performance of the cryocooler immediately leads to a temperature rise, and thus, more stringent management is required as compared with a device that cools the container by filling the container with helium. On the other hand, JP2013-144099A proposes a technique for a superconducting coil device of a liquid-helium-free MRI apparatus, in which a plurality of cryocoolers are provided, their temperatures are monitored, and, in a case in which the cooling performance of one cryocooler decreases, another cryocooler maintains the temperature inside the container.

### SUMMARY OF THE INVENTION

In the related art, in order to prevent a quench of the superconducting coil, the temperature of the superconducting coil or the cooling performance of the cryocooler is monitored to prevent the superconducting coil from reaching the critical temperature. However, in the helium-saving type superconducting coil device, the tolerance to a temperature change is significantly lower than that of the device using helium, and thus it is insufficient to manage only whether superconductivity can be maintained.

The superconducting coil device performs maintenance at regular intervals or at a point in time at which the performance of the cryocooler deteriorates, de-excites the superconducting coil, and then re-excites the superconducting coil after the cryocooler is replaced. In order to avoid a forced quench and to restart operation in a short time after the maintenance, it is important to prevent the superconducting coil from quenching during the maintenance. However, in the related art, the superconducting coil is not managed in consideration of the temperature change that occurs during the maintenance. Therefore, for example, it is not possible to respond to an unexpected situation such as a power outage.

An object of the present invention is, in a helium-saving superconducting coil device having low tolerance to temperature changes of the superconducting coil, to estimate, from the cooling performance of a cryocooler under a normal state, whether the cryocooler has cooling performance that enables re-excitation, thereby improving rapidity and reliability of preventing occurrence of a quench, and, in an imaging apparatus such as an MRI apparatus including the superconducting coil device, even when the refrigeration performance of the cryocooler has deteriorated, to predict imaging feasibility, prevent a quench in advance, and shorten the time until re-driving and re-imaging.

In order to solve the above-described object, the present invention sets one or a plurality of warning temperatures lower than a critical temperature as a temperature for managing a temperature of a superconducting coil. The present invention issues notification information, such as a warning or a message, in accordance with the warning temperature, and provides measures that enable a user to reliably prevent a quench, such as replacement of the cooler and continuation or suspension of operation.

That is, the superconducting coil device according to an aspect of the present invention is a helium-saving superconducting coil device including a superconducting coil housed in a container and at least one cryocooler that is thermally connected to the superconducting coil and cools the superconducting coil, and further includes a processor that inputs temperature information of the superconducting coil detected by a temperature sensor installed in the container and issues a notification to a user. The processor stores a temperature equal to or lower than an excitation-allowable temperature at which excitation of the superconducting coil is allowable as an excitation warning temperature, and issues first notification information in a case in which a temperature of the superconducting coil detected by the temperature sensor exceeds the excitation warning temperature for a predetermined time or longer.

In addition, the MRI apparatus according to an aspect of the present invention is a magnetic resonance imaging apparatus including a static magnetic field generation magnet; and an imaging unit that causes nuclear magnetic resonance in atomic nuclei included in a subject placed in a static magnetic field space generated by the static magnetic field generation magnet to acquire an NMR signal, in which the superconducting coil device according to the embodiment of the present invention is used as a static magnetic field generation magnet.

Further, a temperature management method of a superconducting coil device according to an aspect of the present invention is a method of managing a temperature of a helium-free superconducting coil device and issuing notification information corresponding to the temperature, the method including: setting, as a temperature for managing the superconducting coil, an excitation warning temperature based on a critical temperature of the superconducting coil and a temperature rise due to heat generation during excitation; and issuing information on a replacement time of a cryocooler that cools the superconducting coil, in a case in which a temperature of the superconducting coil detected by a temperature sensor exceeds the excitation warning temperature.

In the present specification, the "critical temperature" is a temperature at which the superconducting coil quenches, and is different depending on the material of the superconducting coil and the environment such as a magnetic field generated by the superconducting coil and a current flowing through the superconducting coil, but is, for example, a temperature of 8 to 10 K. The "excitation-allowable temperature" is a temperature at which the superconducting coil does not reach the critical temperature even in a case in which the excitation is performed, that is, an upper limit temperature at which the excitation operation can be performed. The "excitation warning temperature" is a temperature equal to or higher than a set cooling temperature of the superconducting coil and equal to or lower than the excitation-allowable temperature.

According to the present invention, it is possible to set the excitation warning temperature and to provide information on the cryocooler replacement or to control the excitation operation at the excitation warning temperature. As a result, it is possible to perform the cryocooler replacement at an appropriate time, the excitation operation that reliably prevents the quench, and the imaging operation. In addition, according to the present invention, by setting a warning temperature higher than the excitation warning temperature as the warning temperature to be managed, it is possible to manage the risk of the quench or the like in multiple stages. In particular, in a case in which the present invention is applied to the MRI apparatus, it is possible to perform the coil temperature management in consideration of the temperature rise that occurs during the imaging.

### BRIEF DESCRIPTION OF THE DRAWINGS

FIG. 1 is a diagram showing an overall outline of a superconducting coil device to which the present invention is applied.
FIG. 2 is a diagram showing a flow of processing of coil temperature management and notification issuance.
FIG. 3 is a flowchart of temperature management and notification issuance of the superconducting coil device according to Embodiment 1.
FIG. 4 is a diagram showing a relationship of warning temperatures stored in a processor according to Embodiment 2.
FIG. 5 is a diagram showing an example of notification information according to Embodiment 2.
FIG. 6 is a diagram showing a flow of processing of an application example.
FIG. 7 is a diagram showing an example of notification information of the application example.
FIG. 8 is a diagram showing an overall outline of an MRI apparatus to which the present invention is applied.
FIG. 9 is a functional block diagram of a processor of the MRI apparatus according to the present embodiment.
FIG. 10 is a diagram showing another example of a functional block diagram of the processor.
FIG. 11 is a diagram showing a relationship of warning temperatures set in a processor according to Embodiment 3 and an example thereof.
FIG. 12 is a diagram showing a flow of processing of Embodiment 3.
FIG. 13 is a diagram showing a flow of processing of Embodiment 4.
FIG. 14 is a functional block diagram of a processor and a storage unit according to Embodiment 4.
FIG. 15 is a diagram showing an example of notification information according to Embodiment 4.
FIG. 16 is a diagram showing a flow of processing of Embodiment 5.

### DESCRIPTION OF THE PREFERRED EMBODIMENTS

Hereinafter, embodiments of the present invention will be described with reference to the drawings.

### Embodiment of Superconducting Coil Device

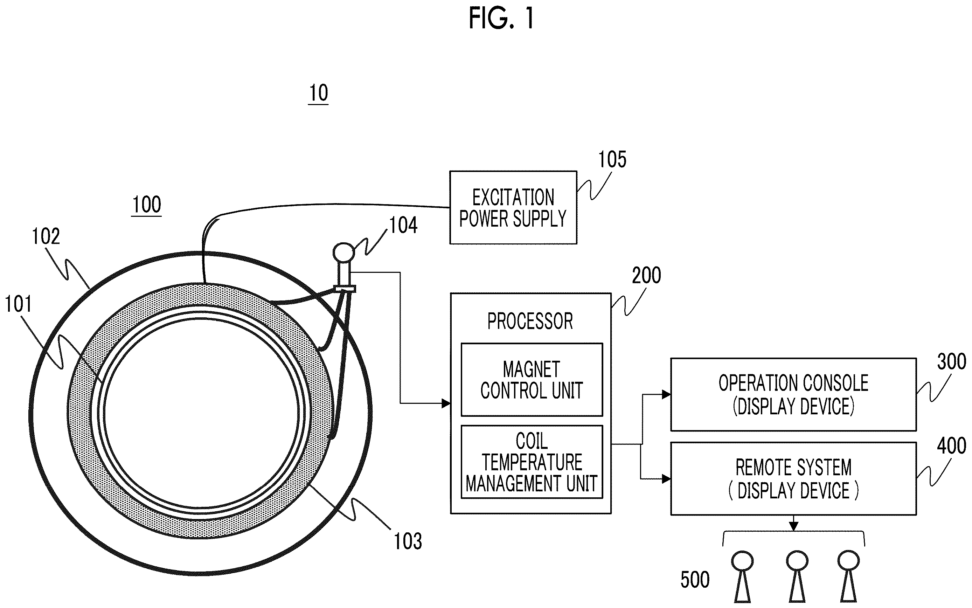

As shown in FIG. 1, a superconducting coil device 10 according to the present embodiment includes, as main components, a superconducting coil 101 disposed in a vacuum container 102, a heat transfer member 103 that covers a periphery of the superconducting coil 101, a cryocooler 104 that cools the superconducting coil 101, and a power supply circuit that de-excites and excites the superconducting coil 101. In the drawing, only an excitation power supply 105 is shown as the power supply circuit. Hereinafter, the superconducting coil 101, the vacuum container 102, and the heat transfer member 103 will be collectively referred to as a coil unit 100. Each element constituting the coil unit 100 is the same as a known superconducting coil, and will be briefly described here, with the detailed description being omitted.

In a case in which the superconducting coil 101 is a coil that generates a magnetic field in a horizontal direction, the superconducting coil 101 is housed in the cylindrical vacuum container 102 in a state in which a wire consisting of a superconducting member is wound around a cylindrical bobbin. However, the direction of the magnetic field generated is not limited to the horizontal direction depending on an application of the superconducting coil device 10, and the present invention can also be applied to a vertical superconducting coil device.

Although not shown, the vacuum container 102 includes two or three layers of thermal shields and is configured to maintain a low temperature state equal to or lower than a critical temperature of the superconducting member. The vacuum container 102 comprises one or more temperature sensors (not shown) that detect a temperature. The temperature information detected by the temperature sensor is sent to a processor (described later) that performs control of the device.

Although only one cryocooler 104 is shown in the drawing, the superconducting coil device 10 may include a plurality of cryocoolers. The cryocooler 104 includes a cold head fixed to the vacuum container 102 and a compressor (compression unit), and a compression refrigerant gas supplied from the compressor to the cold head is adiabatically expanded in the cold head to generate a cooling effect. A distal end of the cold head is inserted into the container, and the container is cooled to a predetermined temperature, thereby cooling the superconducting coil 101 via the heat transfer member 103. The cryocooler 104 is also controlled by the processor to have a cooling capacity that cools an amount of heat that has entered the vacuum container 102 without excess or deficiency. As a result, the superconducting coil 101 is maintained in a thermal equilibrium state, and a closed-type superconducting magnet is realized.

The excitation power supply 105 and a de-excitation power supply (not shown) are electrically disconnected from the superconducting coil 101 while a persistent circuit is formed in the superconducting coil 101, but are connected to the superconducting coil 101 to perform excitation, de-excitation, re-excitation, and the like in a case of forming the persistent circuit, a case of maintenance, a case of a power outage, and the like.

The superconducting coil device 10 further comprises a processor 200 that controls excitation and de-excitation of the superconducting coil 101, controls the cryocooler, and the like. A main function of the processor 200 is control of the power supply circuit and control of the cryocooler (magnet control), but the processor according to the present embodiment is characterized by comprising a function (coil temperature management/alarm function) of performing temperature management in consideration of a temperature rise accompanying predetermined processing performed by an operator or a worker (hereinafter, collectively referred to as a user) who performs maintenance, and issuing a warning to the user.

That is, the processor 200 receives the temperature information (measurement value and elapsed information) of the superconducting coil detected by the temperature sensor installed in the container, and issues a notification to the user. Therefore, the processor 200 stores information on a temperature (referred to as a warning temperature) at which a predetermined warning should be issued in association with the predetermined processing or operation, and compares the warning temperature with the temperature detected by the temperature sensor to perform necessary notification. The predetermined processing or operation is processing or operation that causes a temperature rise in the coil unit due to the processing or operation, and includes, for example, re-excitation of the superconducting coil and an operation of an imaging apparatus using the superconducting coil. The warning temperature is, for example, the critical temperature of the superconducting member and the excitation warning temperature. The critical temperature is a highest temperature required for the superconducting member to maintain the superconducting state, and varies depending on the type of the superconducting member and an environment in which the superconducting coil is placed, such as a magnetic field and a current, but is, for example, 8 to 10 K (Kelvin). The excitation warning temperature is a temperature (excitation warning temperature = excitation-allowable temperature - margin) that has a margin with respect to an excitation-allowable temperature, in a case where a temperature estimated to reach a temperature close to the critical temperature in a case of being excited under set excitation conditions is defined as the excitation-allowable temperature. In addition, in a case where the superconducting coil device is incorporated into an imaging apparatus such as the MRI apparatus, a warning temperature (imaging warning temperature) for issuing a warning of a possibility of a quench due to a temperature rise caused by an operation of the imaging apparatus is set.

The notification issued by the processor 200 can include various warnings such as a warning that the replacement time of the cryocooler is approaching, a warning for immediately replacing the cryocooler, and a notification that informs whether excitation can be performed. An aspect of the notification will be described in detail in the embodiment described later. In a case where the superconducting coil device 10 or the processor 200 comprises a display device 300 as an accessory device, such a notification is displayed on the display device 300. In addition, the notification may be issued to a display device of a remote system 400 that performs maintenance, or to each service staff 500 who belongs to the remote system 400 but is outside the remote system 400. An aspect of the notification is not particularly limited, but may be displayed as a message on the display device, or may be accompanied by a voice or a warning sound. The notification to the service staff 500 or the like can be performed, for example, via a portable device carried by the service staff 500.

The processing by such a processor can be executed by any computer. In addition, any computer may execute these processes using a processor as hardware, a program as software, or a combination thereof. In that case, the processor is configured to execute various types of processes in the present embodiment in cooperation with the program and can function as each unit or each means in the present embodiment. Additionally, the execution order of the process by the processor is not limited to the order described above and may be changed as appropriate. Any computer may be a general purpose computer, a special purpose computer, a workstation, or other system capable of executing each process.

The processor may be configured with one or more pieces of hardware, and the type of hardware is not limited. For example, the processor can be configured using hardware such as a central processing unit (CPU), a micro processing unit (MPU), a programmable logic device such as a field programmable gate array (FPGA), a dedicated circuit for executing specific processing such as an application specific integrated circuit (ASIC), a graphic processing unit (GPU) or a neural processing unit (NPU). Additionally, the type of hardware may be a combination of different types of hardware. In a case where a plurality of hardware components are configured to execute one or a plurality of processes of a certain processor, the plurality of hardware components may be present in physically separate devices or may be present within the same device. In addition, in any of the embodiments, the order of the processes performed by the processor is not limited to the order described above, and may be changed as appropriate. In addition, hardware is implemented in a form of an electric circuit (circuitry) in which circuit elements, such as semiconductor elements, are combined.

Further, the program may be software, such as firmware or a microcode. The program may also be, for example, a group of program modules, and each function may be implemented by a processor configured to execute the corresponding function. The program may be a program code or a plurality of code segments that are stored in one or a plurality of non-transitory computer-readable media (for example, storage media or other storages). The program may be divided and stored in a plurality of non-transitory computer-readable media present in devices physically separated from each other. The program code or the code segment may represent any combination of procedures, functions, subprograms, routines, subroutines, modules, software packages, classes, instructions, data structures, or program statements. The program code or code segments may be connected to other code segments or hardware circuits by transmitting and receiving information, data, arguments, parameters, or contents of a memory.

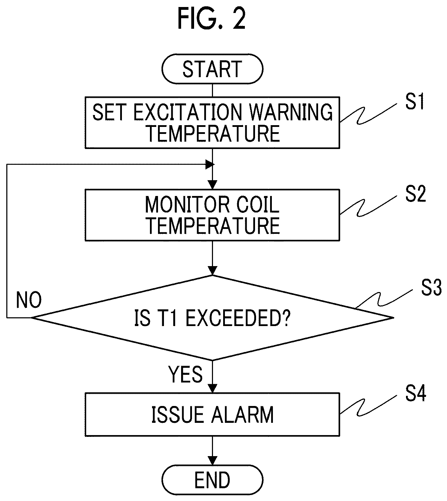

Hereinafter, the flow of temperature management and notification issuance by the processor 200 of the superconducting coil device 10 according to the present embodiment will be described. FIG. 2 shows an example of processing of the processor 200.

In the present embodiment, in a case where the superconducting coil temperature is detected to be higher than the excitation warning temperature for the entire day during the operation of the superconducting coil device 10, the processor 200 provides information on cryocooler replacement.

The excitation warning temperature is set as the temperature to be monitored in order to maintain a temperature (equal to or lower than the excitation-allowable temperature) lower than the critical temperature even in a case where re-excitation is required due to a power outage or the like. That is, in the excitation, the temperature of the superconducting coil is increased in order to pass a current, but in a case where the temperature can no longer be maintained at the excitation-allowable temperature or lower due to the temperature rise caused by the excitation, the superconducting coil is quenched by exceeding the critical temperature due to the excitation, and the excitation cannot be performed.

Accordingly, the excitation warning temperature T1 is set to a temperature higher than the cooling temperature set in the superconducting coil 101 and is set to a temperature T3 (referred to as an excitation-allowable temperature) obtained by subtracting a temperature rise amount due to the excitation from the critical temperature T0 or to a temperature obtained by subtracting a predetermined margin from the excitation-allowable temperature T3. Since the temperature of the superconducting coil may vary depending on the temperature sensor, the excitation warning temperature may vary for each sensor. The margin is a temperature width set to ensure that the critical temperature is not reached even in a case of excitation, and is set, for example, such that the excitation warning temperature T1 is lower than the excitation-allowable temperature T3 by about 1 K.

In a case where the excitation warning temperature is set (S1), the processor 200 (temperature management/alarm unit 220) acquires a temperature value from each temperature sensor in the magnet (S2), and determines whether the temperature value exceeds the excitation warning temperature (S3). In a case where the cryocooler 104 maintains a certain performance, the temperature in the vacuum container 102 is maintained substantially constant by the cryocooler 104 even in a case where the temperature momentarily exceeds the excitation warning temperature. In a case where the performance of the cryocooler 104 deteriorates, the number of times the temperature exceeds the excitation warning temperature increases, and the temperature of the vacuum container 102 gradually increases.

In a case where the temperature value from each temperature sensor exceeds the excitation warning temperature for a predetermined time, information on the cryocooler replacement is issued (S4). Since the temperature in the container fluctuates with a small fluctuation width even in a case of being maintained at a constant temperature, the predetermined time for determining whether the temperature exceeds the excitation warning temperature may be a cumulative time as well as a continuous time. For example, it may be determined that the temperature exceeds the excitation warning temperature in a case where the cumulative time of exceeding the excitation warning temperature is a predetermined time. As a result, it is possible to eliminate oscillation between exceeding and not exceeding due to the fluctuation.

In addition, in a case of a plurality of sensors, a warning may be issued in a case where all of the plurality of temperature values exceed the excitation warning temperature, but for example, a warning may be issued in a case where the temperature value from a sensor at a predetermined position exceeds the excitation warning temperature or in a case where a predetermined ratio or more of the plurality of sensors exceed the excitation warning temperature.

According to the superconducting coil device 10 according to the present embodiment, the processor 200 can perform predetermined processing that affects the temperature management of the superconducting coil device 10, and specifically can store a warning temperature related to the excitation operation and issue an appropriate warning such as information on the cryocooler replacement based on the detected temperature of the superconducting coil. In addition, according to the present embodiment, by setting a temperature (excitation warning temperature) lower than the excitation-allowable temperature as the warning temperature to be monitored, it is possible to maintain a state in which, for example, immediate response to temporary de-excitation and excitation required for responding to a power outage or the like is possible.

Hereinafter, a specific embodiment of the temperature management method by the superconducting coil device 10 according to the present embodiment will be described. In the following description, FIGS. 1 and 2 will be referred to again as necessary.

### Embodiment 1

In the present embodiment, setting the excitation warning temperature in the processor 200 (S1) and determining whether the temperature value from each temperature sensor in the magnet exceeds the excitation warning temperature based on the excitation warning temperature (S2, S3) are the same as the processing of the processor (FIG. 2) described in the above-described embodiment.

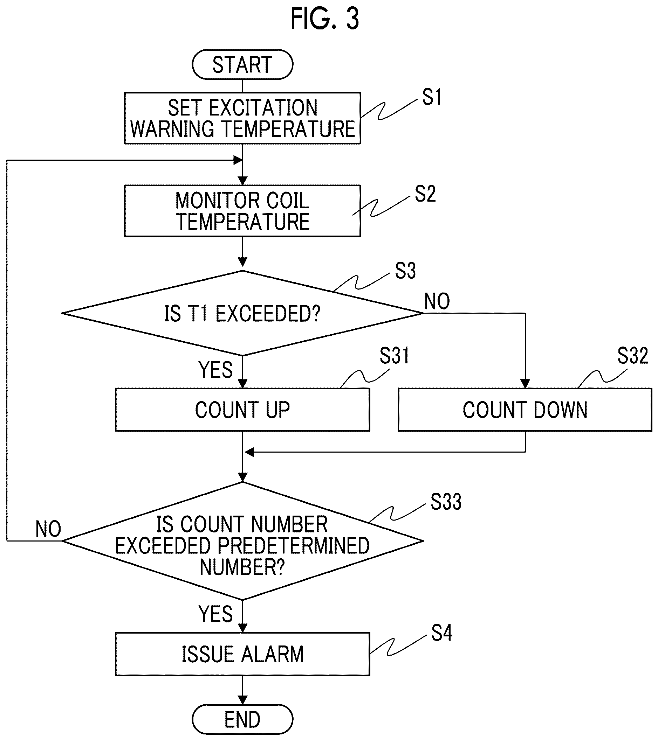

In the present embodiment, as shown in FIG. 3, in order to determine the deterioration of the performance of the cryocooler 104 in S3, the processor 200 acquires the temperature from the temperature sensor at regular intervals, for example, at a frequency of 1 time/minute. A count value is provided for each temperature, and the count value is counted up in a case where the temperature exceeds the excitation warning temperature and is counted down in a case where the temperature is lower than the excitation warning temperature (S31, S32). The count value is stored in the processor 200. In a case where the stored count number reaches a count number (count number 1440) for 24 hours (S33), the processor 200 provides information on the cryocooler replacement (S4).

For example, in a case where the predetermined number is reached, the processor 200 outputs a warning message such as "The cryocooler replacement time is approaching" to a user operation console (display device 300) for operating the superconducting coil device 10, and notifies the remote system 400 that a warning has occurred. The remote system 400 notifies the service staff 500 of an occurrence of a warning by e-mail. In response to the notification, the service staff views a detailed status of the magnet, and in a case where the continuous exceeding of the magnet temperature over the excitation warning temperature can be confirmed, takes actions such as planning the cryocooler replacement.

According to the present embodiment, by managing the exceeding of the excitation warning temperature in terms of the count number, it is possible to reliably determine the exceeding of the excitation warning temperature while allowing a slight fluctuation of the container temperature, and it is possible to provide information on the cryocooler replacement at an appropriate time.

### Embodiment 2

In the present embodiment as well, as in the flow shown in FIG. 3, the temperature from the temperature sensor is monitored (S1), the count is counted up or counted down depending on whether or not the temperature exceeds the excitation warning temperature (S2 to S3), and the information on the cryocooler is provided in a case where the count number exceeds the predetermined number (S4) are the same as in Embodiment 1.

In the present embodiment, the feature is to change the excitation condition in advance in a case where the excitation warning temperature is exceeded, in addition to the information on the cryocooler or instead of the information on the cryocooler (S5). The changed excitation condition is a condition under which heat generation due to the excitation can be suppressed, and is, for example, a time (excitation time) from the start of the excitation to the completion of the excitation. The excitation time can be changed by adjusting the amount of current flowing through the superconducting coil.

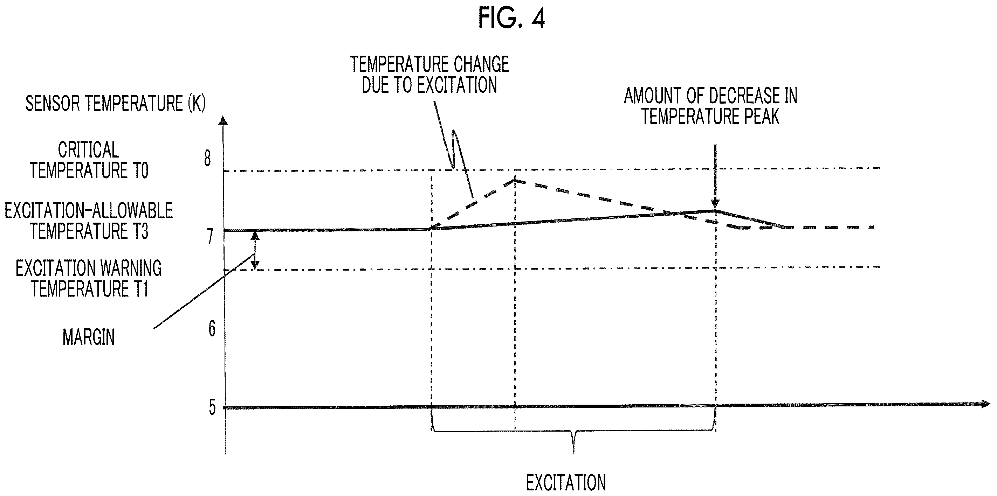

Since the excitation is performed by passing a predetermined current to the superconducting coil, the superconducting coil generates a small amount of heat. The amount of heat generated from the start to the completion of the excitation is constant regardless of the excitation time, but the temperature rise due to the generated heat is offset by the cooling effect generated during the extended time by extending the excitation time, so that, as shown in the graph of FIG. 4, in a case of the standard excitation time, the temperature of the superconducting coil changes as shown by the dotted line, and approaches the critical temperature T0 due to the excitation, but by extending the excitation time, the temperature rise is suppressed as shown by the solid line, and the temperature lower than the critical temperature T0 can be maintained. That is, since the peak of the rising temperature is lower than that in a case where the excitation time is not extended, the temperature rise can be suppressed. (change shown by dotted line in FIG. 4)

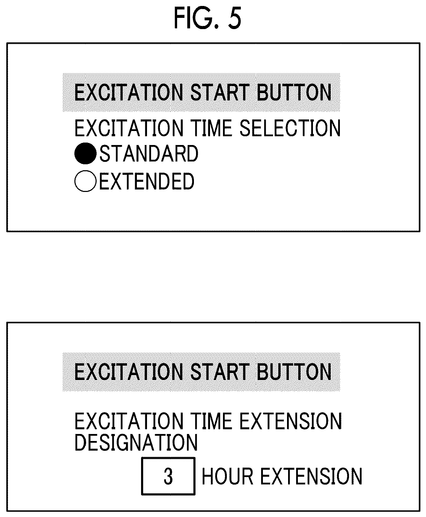

The processor 200 may automatically change the excitation time in a case where the excitation warning temperature is exceeded, or may change the excitation time in a case where the excitation-allowable temperature is approached. The criterion for approaching the excitation-allowable temperature can be, for example, a case where the sensor temperature is "(excitation-allowable temperature × 9 + excitation warning temperature × 1)/10". Further, the processor 200 may be configured to display a GUI as shown in FIG. 5 on the display device, to allow the user to designate the extension of the excitation time or the time to be extended, and to change the excitation time in accordance with the designation of the user. In FIG. 5, an example of a UI for selecting whether or not to extend the excitation time and an example of a UI for designating the extension time of the excitation are shown, but a UI for selecting the stop of the excitation or the like may be further displayed.

According to the present embodiment, by changing the excitation condition in a case where the sensor temperature exceeds the excitation warning temperature or in a case where the excitation-allowable temperature is approached, the temperature rise due to the excitation of the superconducting coil device can be suppressed even in a case where the cryocooler cannot be immediately replaced, and the risk of the quench can be reduced. In addition, since the change of the excitation condition can be performed not only in a case of actually starting the excitation operation but also in a normal state according to the present embodiment, the sense of security of the user who performs the excitation operation can be increased.

In the present embodiment, as a modification example, the information on the cryocooler may be omitted and only the change of the excitation time may be performed, and such a modification example is also included in the present embodiment.

### Application example of Embodiments 1 and 2

In Embodiments 1 and 2, the periodic temperature management based on the excitation warning temperature and the information on the cryocooler or the change of the excitation condition have been described, but in the present application example, in addition to these functions, in a case of starting the excitation, it is determined whether or not the superconducting coil temperature (sensor temperature) exceeds the excitation warning temperature, and in a case where the superconducting coil temperature exceeds the excitation warning temperature, a warning message is issued again.

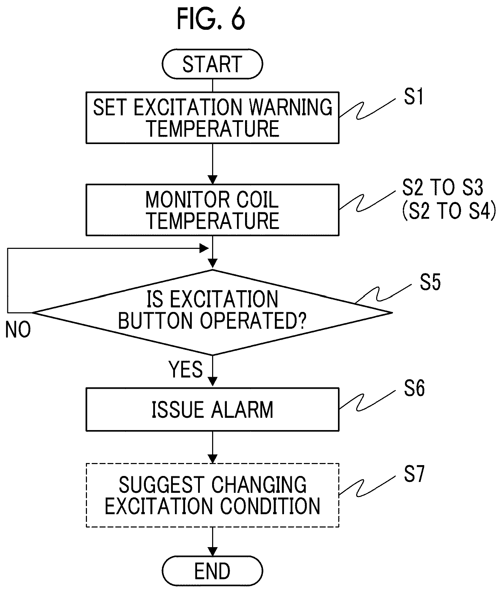

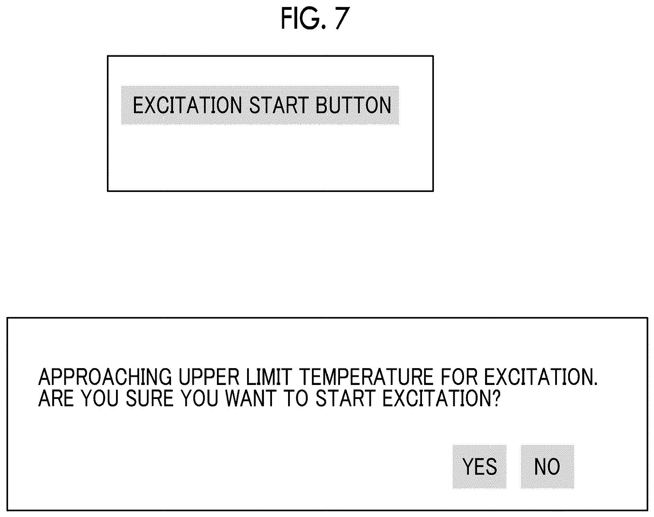

That is, in the present application example, as shown in FIG. 6, in a case where the excitation start button is pressed during the execution of the count or after the information on the cryocooler (S5), in a case where the sensor temperature exceeds the excitation warning temperature or in a case where the count number stored in the processor 200 exceeds the predetermined number as in Embodiment 1, the second warning message is issued to the user again (S6). The warning message is, for example, as shown in FIG. 7, a message for confirming whether or not the sensor temperature is approaching the upper limit of the excitation-allowable temperature and whether or not the excitation can be performed. The warning message is displayed on the operation console at a location where the excitation start button is provided, for example, in the form of a pop-up. In this case, a warning sound or a voice may be used.

In addition, a GUI displays a "Yes" button and a "No" button together with a message such as "Are you sure you want to start excitation?", and in a case where "Yes" is selected, the excitation is started, and in a case where "No" is selected, the excitation is not performed. In a case where "Yes" is selected, a message (FIG. 5) for changing the excitation condition as in Embodiment 2 may be used as the alarm (S7).

According to the present application example, by issuing the information on whether or not the excitation can be continued under the set condition as the warning message immediately before the excitation, it is possible to notify the user that the operation is likely to cause the quench in a case of performing the excitation in a state where the cryocooler is deteriorated. As a result, the user can avoid unnecessary excitation, and the quench can be reliably avoided.

Although the embodiment of the superconducting coil device according to the present invention and the temperature management and alarm thereof have been described above, the superconducting coil device according to the embodiment of the present invention can be applied to an imaging apparatus such as an MRI apparatus, a nuclear magnetic resonance analysis apparatus, and the like. Hereinafter, an embodiment of the MRI apparatus including the superconducting coil device according to the embodiment of the present invention will be described.

### Embodiment of MRI apparatus

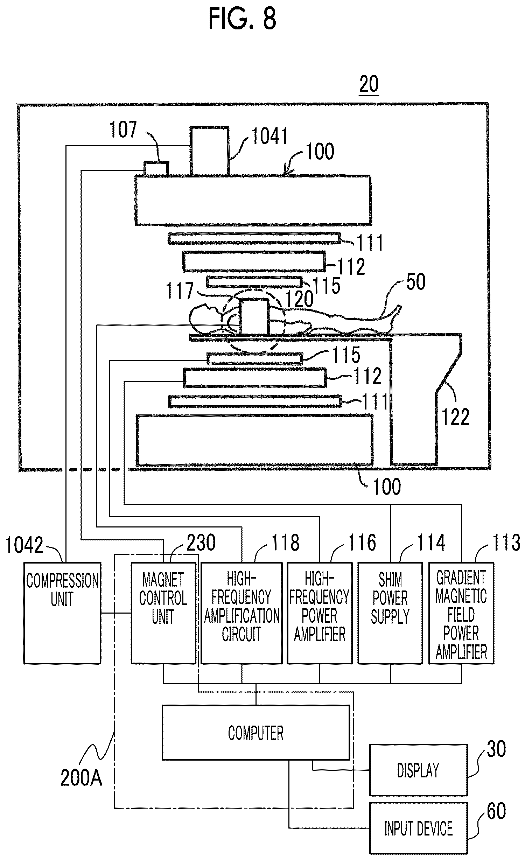

First, an outline of the MRI apparatus will be described. The MRI apparatus 20 mainly consists of an imaging unit that performs imaging and a processor 200A that performs calculation such as control of the apparatus and image generation. A main configuration of the imaging unit is the same as that of a known MRI apparatus, and as shown in FIG. 8, the imaging unit includes a static magnetic field generation device that generates a uniform static magnetic field in an imaging space on which a subject 50 is placed, a shim coil 111 that generates a magnetic field for correcting inhomogeneity of the static magnetic field, a gradient magnetic field coil 112 that applies a magnetic field gradient to the static magnetic field, an RF transmission coil 115 that applies a high-frequency magnetic field having a frequency (nuclear magnetic resonance frequency) determined by the intensity of the static magnetic field to the subject, and an RF reception coil 117 that detects a nuclear magnetic resonance signal generated from the subject by the application of the high-frequency magnetic field.

The shim coil 111 and the gradient magnetic field coil 112 are connected to a shim power supply 114 and a gradient magnetic field power amplifier (gradient magnetic field power supply) 113, respectively. The RF transmission coil 115 is connected to an RF transmission unit comprising a high-frequency amplification circuit 116 or the like, and the RF reception coil 117 is connected to an RF reception unit comprising a high-frequency power amplifier 118, an A/D converter, or the like.

Operations of the shim power supply 114, the gradient magnetic field power supply, the RF transmission unit, and the RF reception unit are controlled by the processor 200A via a sequencer (not shown). In the control by the processor 200A, the imaging control via the sequencer and the calculation such as image reconstruction using the nuclear magnetic resonance signal received by the RF reception unit are realized by a computer that functions as the processor 200A in the embodiment shown in the drawing.

The MRI apparatus according to the present embodiment uses the superconducting coil device 10 described above as the static magnetic field generation device, and as shown in FIG. 1, the superconducting coil device 10 comprises the coil unit 100 including the superconducting coil 101 accommodated in the vacuum container 102 and the cryocooler 104 that cools the superconducting coil 101. In FIG. 8, a cold head 1041 and a compression unit 1042 are shown as elements of the cryocooler 104. Each element constituting the superconducting coil device 10 is as described in the embodiment of the superconducting coil device 10, and the overlapping description will be omitted.

The vacuum container 102 comprises a sensor connection terminal 109 to which the temperature sensor installed in the coil unit 100 is connected. The sensor connection terminal 109 is connected to the processor 200A (magnet control unit 230). The magnet control unit 230 receives the temperature detected by the temperature sensor, monitors an operation state of the superconducting coil 101, and controls the cryocooler 104 to perform the temperature management.

The processor 200A comprises a function of controlling the static magnetic field generation device (superconducting coil 101) and a function of issuing a warning to the user using the temperature information from the temperature sensor, in addition to the imaging control of the MRI apparatus 20 and the calculation using the nuclear magnetic resonance signal.

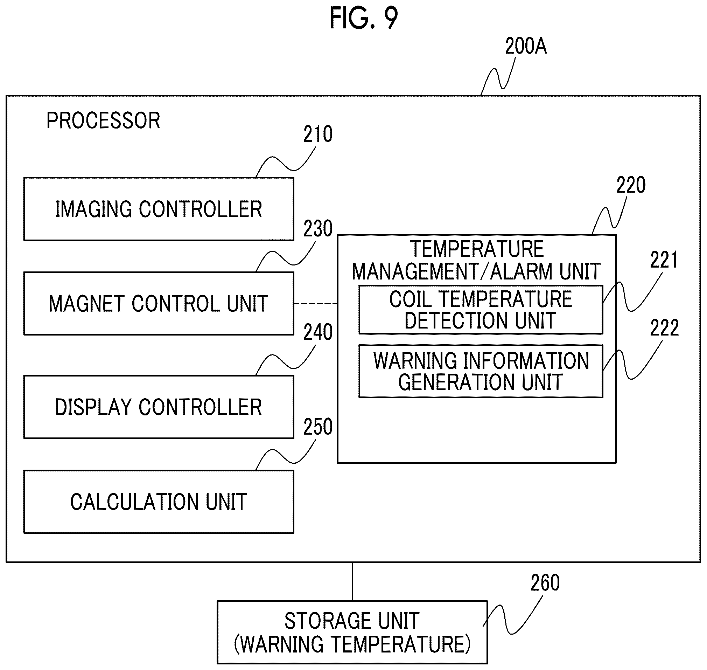

FIG. 9 shows a functional block diagram of the processor 200A that realizes these functions. As shown in the drawing, the processor 200A includes an imaging controller 210 that controls the imaging of the MRI apparatus 20, a calculation unit 250 that performs various types of calculation such as image reconstruction, a display controller 240 that generates and controls the display of a display image displayed on the display 30, and the magnet control unit 230 and the temperature management/alarm unit 220. In FIG. 8, the magnet control unit 230 and the temperature management/alarm unit 220 are shown as independent units in order to easily understand the functions, but these may be one unit. The same applies to other control units.

Further, the processor 200A is provided with a storage unit 260 that stores a plurality of temperatures (warning temperatures) required for managing the magnet temperature. The storage unit 260 may be an internal memory of the computer, an external storage device, or may be configured by a plurality of storage units.

Since the imaging operation of the MRI apparatus 20 having the above-described configuration is the same as that of a known MRI apparatus, the description thereof will be omitted here, and the function of the temperature management/alarm unit 220 of the processor 200A will be mainly described below.

The function of the temperature management/alarm unit 220 of the processor 200A according to the present embodiment is the same as the temperature management function of the processor 200A of the superconducting coil device 10 described above. That is, the functions described in Embodiments 1 and 2 and the modification example thereof are incorporated. That is, as shown in FIG. 2, the processor 200A of the MRI apparatus 20 according to the present embodiment stores the excitation warning temperature, receives the temperature of the sensor installed in the vacuum container of the static magnetic field generation device (superconducting coil device) based on the excitation warning temperature, and determines whether or not the sensor temperature exceeds the excitation warning temperature for a certain period. In a case where the excitation warning temperature is exceeded, information on the cryocooler replacement is provided to notify that the cryocooler replacement time is approaching. In addition, the excitation condition may be changed automatically or based on the user designation. In addition, in a case where it is determined that the excitation warning temperature is exceeded in a case of performing the excitation, a warning may be issued again as to whether or not to proceed with the excitation operation, and the excitation condition may be changed at the same time.

The temperature management/alarm unit 220 according to the present embodiment can include control related to the imaging operation that affects the temperature of the superconducting coil, in addition to the above-described functions.

In a case where the superconducting coil 101 can be excited once, the quench does not occur and the imaging can be performed even in a state where the excitation-allowable temperature is slightly exceeded due to the deterioration of the performance of the cryocooler (since the temperature is lower than the critical temperature), but in a case where the deterioration proceeds as it is, the temperature exceeds the imaging allowable temperature, and there is a concern that the temperature may rise due to various influences such as an induced current from the gradient magnetic field during the imaging operation and exceed the critical temperature. In the present embodiment, by setting the imaging warning temperature as the second warning temperature in addition to the excitation warning temperature, the quench is reliably avoided and the imaging allowable state is maintained.

Hereinafter, an embodiment of the operation of the processor 200A will be described with the control function of the temperature management/alarm unit 220 related to the imaging operation as the center.

### Embodiment of Temperature Management in MRI Apparatus

### Embodiment 3

The present embodiment is characterized in that the imaging warning temperature set to be equal to or lower than the imaging allowable temperature is monitored to issue a warning in a case where the imaging warning temperature is exceeded in order to maintain the state in which the MRI apparatus 20 can perform the imaging, and the imaging warning temperature is stored together with the excitation warning temperature of the superconducting coil device 10, and an alarm (first notification information) based on the excitation warning temperature and an alarm (second notification information alarm) based on the imaging warning temperature are issued.

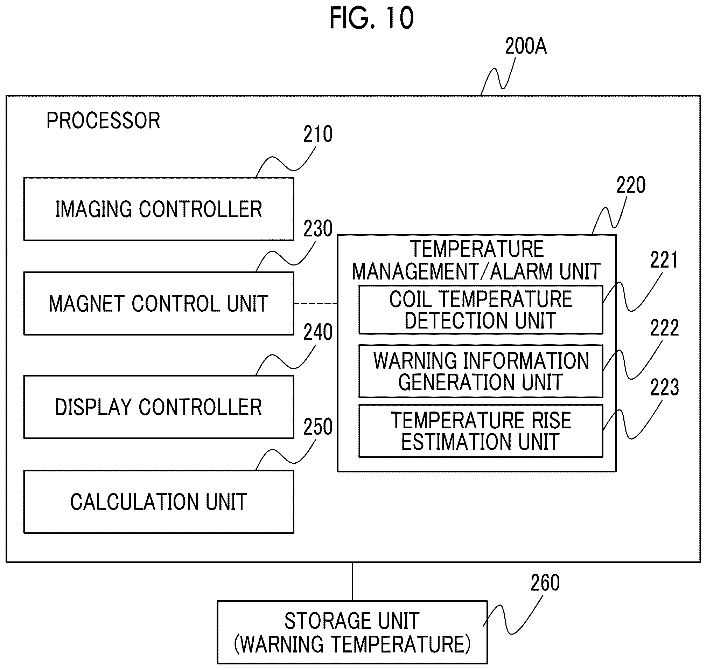

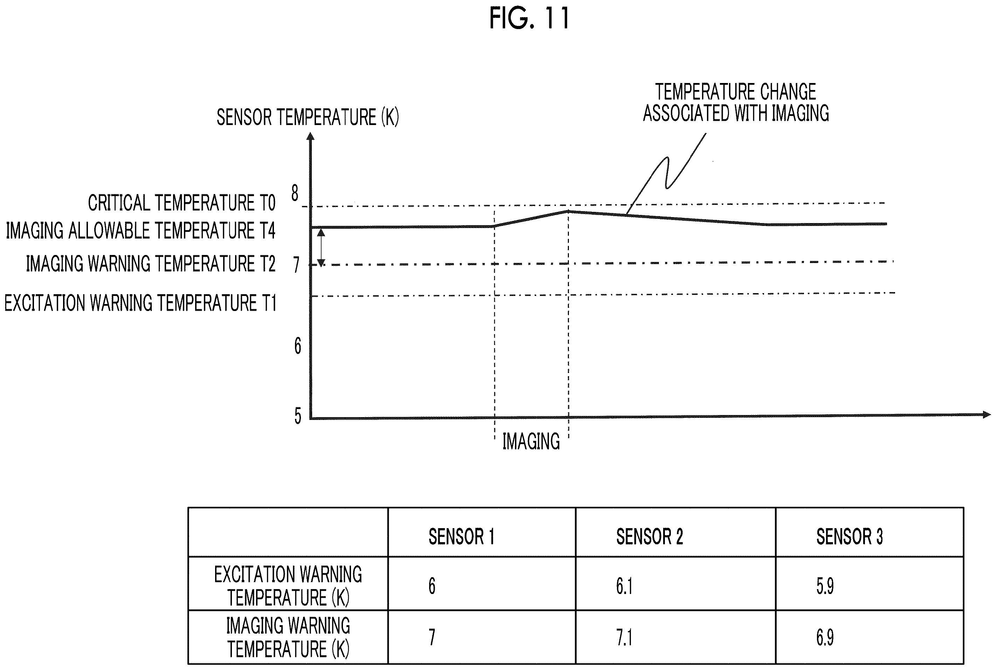

The imaging allowable temperature is a temperature obtained by subtracting a temperature change due to the imaging from the critical temperature, and the imaging warning temperature is a temperature obtained by subtracting a predetermined margin (safety margin) from the imaging allowable temperature. FIG. 11 shows a relationship between the imaging allowable temperature T4, the imaging warning temperature T2, and the excitation warning temperature T1. In addition, an example of the critical temperature, the excitation warning temperature, and the imaging warning temperature is shown below FIG. 11. However, this is merely an example and does not limit the present invention. The imaging allowable temperature may be stored in the storage unit as a temperature obtained by subtracting a maximum value of "temperature change due to imaging" from the critical temperature. Alternatively, since the "temperature change due to imaging" varies depending on the imaging conditions, that is, a pulse sequence (sequence type, 2D sequence or 3D sequence) used for the imaging, imaging parameters (TE, TR, FOV, number of slices, and speed-up number), and a time required for the imaging, a temperature rise estimation unit 223 is provided as shown in FIG. 10, and the processor 200A (temperature rise estimation unit 223) estimates and stores a temperature change amount in various types of imaging in advance. A method of estimating the temperature change amount will be described later.

In addition, since the temperature change amount due to the imaging is generally smaller than the temperature change due to the excitation in which a large current is passed through the superconducting coil, the imaging allowable temperature is higher than the excitation-allowable temperature. That is, the imaging warning temperature is set to a temperature higher than the excitation warning temperature. Accordingly, since the imaging cannot be performed immediately in a case where the imaging allowable temperature is exceeded, a higher-urgency warning is issued than in a case where the excitation warning temperature is exceeded.

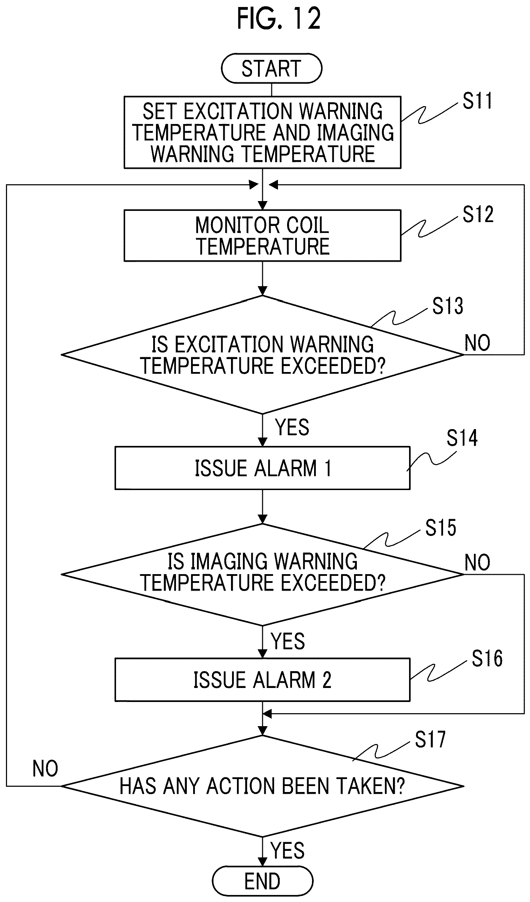

Hereinafter, the operation of the processor 200A will be described with reference to FIG. 12.

In a case where the imaging conditions are determined for imaging, the processor 200A calculates the imaging allowable temperature based on the estimated temperature rise amount from the imaging conditions, and sets the imaging warning temperature in the storage unit 260 (S11). At the same time, the excitation warning temperature is set. The excitation warning temperature may be stored by default.

Next, the temperature management/alarm unit 220 (coil temperature detection unit 221) monitors the sensor temperature of the superconducting coil 101 (S12). In monitoring the sensor temperature, in a case where the sensor temperature exceeds the excitation warning temperature for a predetermined period or for a predetermined count number, a warning information generation unit 222 issues the information on cryocooler replacement (first notification information: alarm 1) to the department (remote system 400) that performs the maintenance of the superconducting coil 101 or the like (S13, S14). The alarm 1 may be issued to the display 30 of the MRI apparatus 20 during the imaging.

The temperature management/alarm unit 220 acquires the temperature information from the sensor even after the alarm 1 is issued (S14), and continues to monitor the superconducting coil temperature. In this case as well, for example, as in Embodiment 1, the sensor temperature is acquired at a predetermined frequency, the count is counted up in a case where the sensor temperature exceeds the imaging warning temperature, the count is counted down in a case where the sensor temperature is equal to or lower than the imaging warning temperature, and it is determined that the sensor temperature exceeds the imaging warning temperature for a predetermined time in a case where the count number reaches a predetermined number (S15). In a case where it is determined that the sensor temperature of the superconducting coil 101 exceeds the imaging warning temperature, the temperature management/alarm unit 220 issues the second notification information (alarm 2) (S16). The alarm 2 may have the same content as the alarm 1, but since the urgency of the cryocooler replacement is higher at the time of issuing the alarm 2 than at the time of issuing the alarm 1, it is preferable to change the alarm to indicate this, for example, to change a frame of the message to a color that attracts more attention than the alarm 1, or to change the content of the message to a content indicating higher urgency than the content of the alarm 1, such as "The cryocooler replacement time is approaching". The alarm 2 is issued to the department (remote system 400) that performs the maintenance of the superconducting coil 101. As with alarm 1, the remote system notifies the service staff by e-mail of occurrence of the warning. The service staff can view the detailed status of the superconducting coil 101 and take measures such as planning cryocooler replacement in a case where the continuous exceeding of the coil temperature over the imaging warning temperature can be confirmed. After the measures are taken, the process returns to the original monitoring step (S17).

According to the present embodiment, by setting and storing a plurality of temperatures as the warning temperature for managing the temperature of the superconducting coil 101, it is possible to issue an appropriate alarm corresponding to each temperature. In particular, in a case of high urgency, it is possible to perform maintenance according to the urgency, such as immediately arranging the cryocooler replacement instead of the imaging by the imaging apparatus. As a result, it is possible to ensure the continuation of the safe imaging operation.

In the present embodiment, a case where the "information on cryocooler replacement" (alarm 1) based on the excitation warning temperature and the "information on cryocooler replacement" (alarm 2) based on the imaging warning temperature are issued has been described, but a modification example in which the former is omitted and only the latter is executed is also included in the present invention.

### Embodiment 4

In Embodiment 3, the temperature management/alarm unit 220 issues a warning, for example, the "information on cryocooler replacement" in a case where the imaging warning temperature is exceeded, but the present embodiment is characterized in that a message for proposing an imaging sequence or imaging conditions is issued in a case where the imaging warning temperature is exceeded at the start of the imaging.

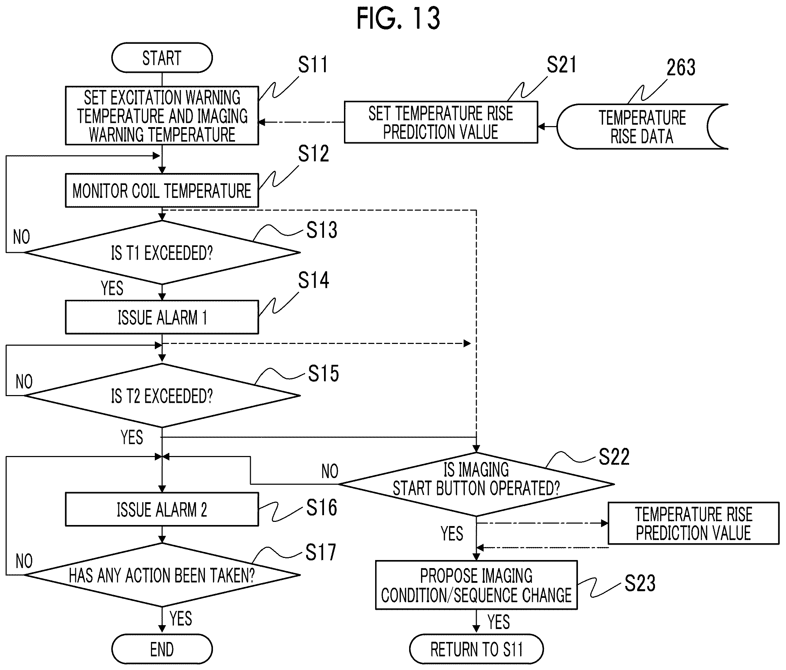

Hereinafter, the processing of the temperature management/alarm unit 220 according to the present embodiment will be described with reference to the flow of FIG. 13.

In the present embodiment as well, the operation in a normal state is the same as in Embodiment 3, the excitation warning temperature and the imaging warning temperature are set (S11), the sensor temperature is monitored (S12), and in a case where the sensor temperature exceeds the excitation warning temperature for a predetermined time, the "information on cryocooler replacement" is generated to determine the time or the count number in which the imaging warning temperature is exceeded (S13, S15). In a case where each warning temperature is exceeded, the alarm 1 and the alarm 2 related to the cryocooler replacement are issued (S14, S16).

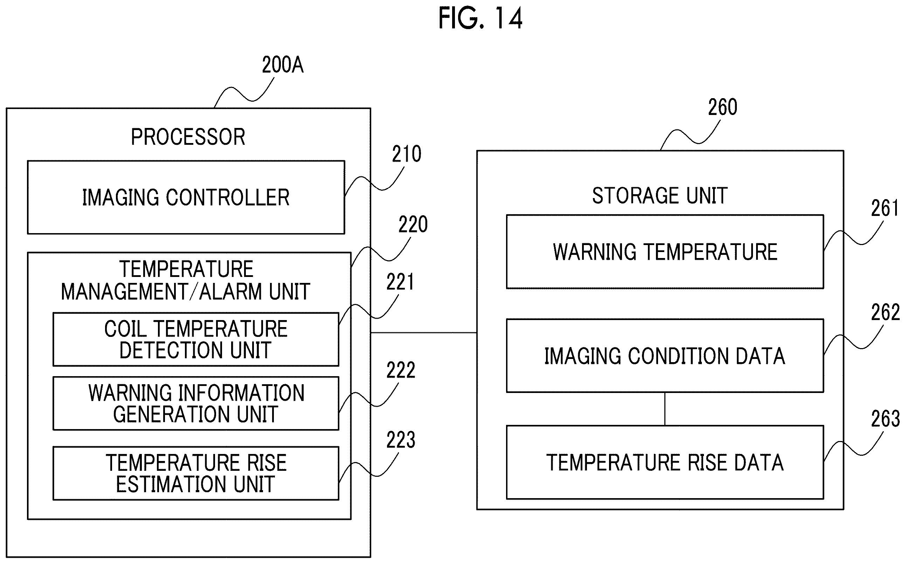

In the present embodiment, in a case where the imaging conditions are set in the imaging controller 210 for imaging, the temperature management/alarm unit 220 first receives the set imaging conditions from the imaging controller 210, and predicts the temperature rise amount of the superconducting coil 101 expected by the scheduled imaging. As described above, the temperature rise amount is determined by the imaging sequence, the imaging parameters, and the like (collectively referred to as the imaging conditions). As shown in FIG. 14, the processor 200A obtains a prediction value of the temperature rise (temperature rise data 263) in advance for various imaging conditions by using a method of using an actual measured value or a statistical value, a simulation, a prediction by AI based on an experience value, or the like, and stores the prediction value in the storage unit 260 in association with the imaging conditions (imaging condition data 262). The actual measured value can be stored in the storage unit, for example, by recording the temperature rise monitored by the temperature sensor in a case of performing the imaging under various imaging conditions, and can be recorded in advance in association with each imaging condition.

The temperature management/alarm unit 220 estimates the imaging allowable temperature by using the prediction value of the temperature rise for each imaging condition, and sets the imaging warning temperature based on the estimated imaging allowable temperature (S12). In addition, a value of the temperature rise amount associated with the scheduled imaging conditions is read out from the storage unit 260 and set as the temperature rise prediction value (S21). In a case where the temperature rise data 263 for each imaging condition is not stored in advance, the prediction value is set to a fixed value such as 0 (zero) or the "maximum value of the temperature change due to the imaging" stored in the storage unit.

The temperature management/alarm unit 220 continuously acquires the coil temperature information from the temperature sensor even before the imaging start button is operated. After determining that the coil temperature exceeds the imaging warning temperature (S15), in a case where the operator (user) of the MRI apparatus 20 operates the imaging start button (S22), the message for confirming the measurement of the imaging or changing the imaging conditions is displayed on the operation console (display 30) of the MRI apparatus 20 via the display controller 240 (S23). In a case where the prediction value of the temperature rise is set, it is also possible to propose the imaging conditions based on the prediction value, to issue a re-warning before the imaging, and the like.

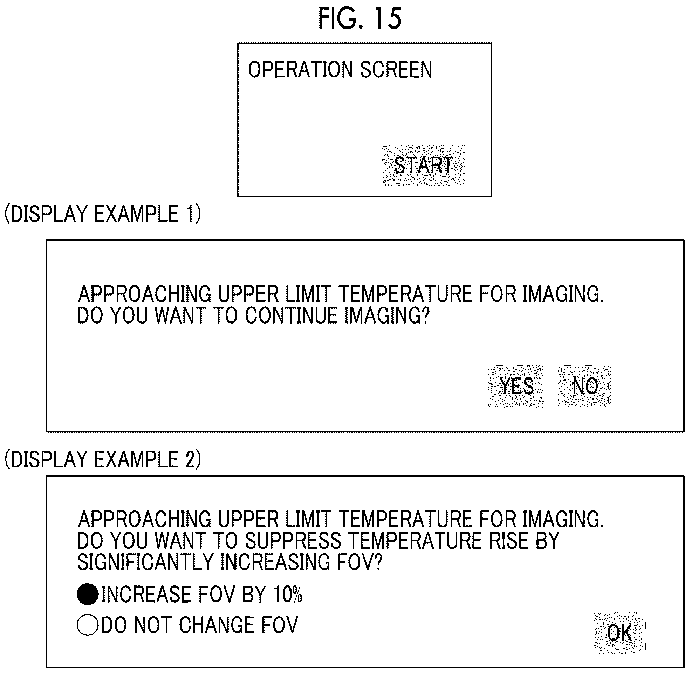

FIG. 15 shows an example of the message displayed on the operation console (display 30) of the MRI apparatus 20.

The upper side of FIG. 15 is a message for confirming the continuation of the imaging, and in a case where "Yes" is operated among the GUIs (Yes, No) displayed together with the message, the imaging is continued, and in a case where "No" is operated, the imaging is stopped.

The message shown on the lower side of FIG. 15 is a message for changing the imaging conditions (FOV in the example shown in the drawing), and proposes to suppress the temperature rise by changing the imaging conditions to increase the FOV. In this case, for example, in a case where the user selects "increase FOV by 10%", the FOV is automatically changed to start the imaging. In a case where "Do not change FOV" is selected for "FOV", the imaging initially set is started. The change of the imaging conditions is not limited to "FOV", and may be the number of slices or the slice thickness as long as the conditions contribute to the temperature rise, and in a case of the series of imaging including a plurality of imaging, the change may be to omit any of the plurality of imaging, and a combination thereof can also be adopted.

The warning (for example, the upper side of FIG. 15) for notifying that the upper limit temperature for the imaging is approached and the warning (for example, the lower side of FIG. 15) related to the change of the imaging conditions may be only one of the warnings, but in a case where the imaging continuation (Yes) is selected in the message screen shown in FIG. 15, the message related to the change of the imaging conditions may be further displayed.

According to the present embodiment, it is possible to issue an appropriate warning even for an operation that causes the temperature rise of the superconducting coil generated during the operation of the imaging apparatus including the superconducting coil 101, and it is possible to ensure the continuation of the safe imaging operation. In particular, by presenting the message related to the imaging conditions, it is possible to prompt the user to determine the imaging continuation and to prompt the user to set or change the imaging conditions. For example, the user can suppress the temperature rise by increasing the FOV, which is the imaging condition, to weaken the gradient magnetic field intensity that contributes to the heat generation.

In the present embodiment, a case where the monitoring based on the imaging warning temperature and the warning related to the imaging continuation are performed together with the monitoring based on the excitation warning temperature and the information on cryocooler replacement has been described, but a modification example in which the former (that is, the monitoring based on the excitation warning temperature and the information on cryocooler replacement) is omitted and only the latter is executed is also included in the present invention.

### Embodiment 5

In Embodiment 4, the imaging sequence or the imaging conditions are proposed in a case where the imaging warning temperature is exceeded, but the present embodiment is characterized in that only the "warning of the temperature rise state" is issued.

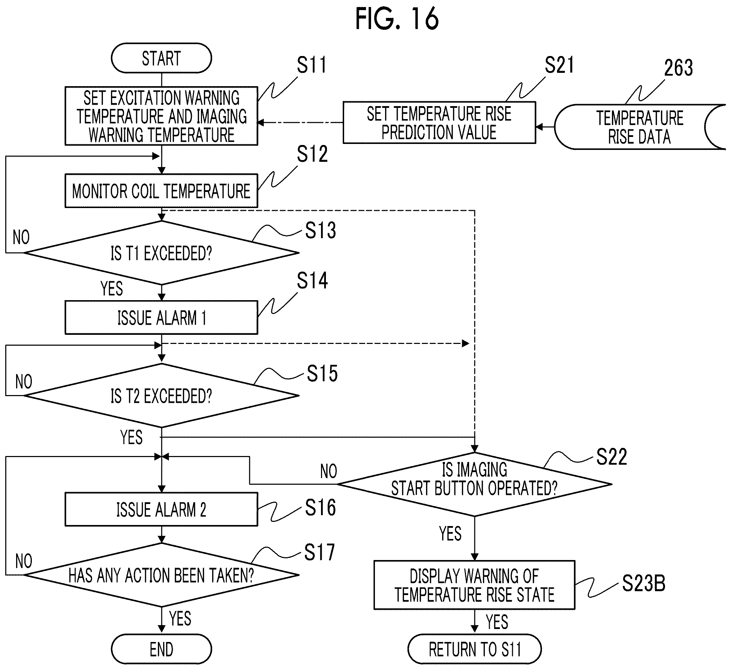

Hereinafter, the processing of the temperature management/alarm unit 220 according to the present embodiment will be described with reference to the flow of FIG. 16.

In the present embodiment as well, the operation in a normal state is the same as in Embodiment 3, the excitation warning temperature and the imaging warning temperature are set (S11), the sensor temperature is monitored (S12), and in a case where the sensor temperature exceeds the excitation warning temperature for a predetermined time, the "information on cryocooler replacement" is generated to determine the time or the count number in which the imaging warning temperature is exceeded (S13, S15). In a case where each warning temperature is exceeded, the alarm 1 and the alarm 2 related to the cryocooler replacement are issued (S14, S16).

The temperature management/alarm unit 220 continues to acquire the coil temperature information from the temperature sensor before the imaging start button is operated, and determines that the coil temperature exceeds the imaging warning temperature (S15). In a case where the operator (user) of the MRI apparatus 20 operates the imaging start button (S22), a warning message that the temperature rise state is present is displayed on the operation console (display 30) of the MRI apparatus 20 via the display controller 240 (S23B).

The message displayed on the operation console (display 30) of the MRI apparatus 20 is, for example, a message as shown in FIG. 15 (display example 1). In a case where "Yes" is operated among the GUIs (Yes, No) displayed together with the message, the imaging is continued, and in a case where "No" is operated, the imaging is stopped.

### Application Example

In the embodiment shown in FIG. 13, the warning in a case where the imaging start button is pressed in a case where the coil temperature of the superconducting coil 101 exceeds the imaging warning temperature has been described, but in a case where the temperature rise prediction value is set in advance for the imaging conditions, as shown by the dotted line in FIGS. 13 and 16, even in a case where the imaging warning temperature is not exceeded, the coil temperature reached during the imaging may be estimated from the coil temperature at that time and the set temperature rise prediction value in a case where the imaging start button is pressed, and the warning as shown in FIG. 15 may be issued in a case where the estimated temperature reaches the imaging warning temperature.

According to this application example, it is possible to distinguish the magnitude of the risk of the quench in a case of performing the imaging in a state where the cryocooler is deteriorated. That is, before the second alarm 2 "information on cryocooler replacement" is issued, it is possible to notify the user that the imaging warning temperature is approached and that the imaging warning temperature may be reached by the imaging at the time of the operation of the imaging start button, and it is possible to avoid the imaging with a large temperature rise.

Although the embodiments of the superconducting coil device and the MRI apparatus according to the present invention have been described above, the present invention is not limited to these embodiments, and for example, it is also possible to combine or substitute the elements and the procedures included in each embodiment as long as there is no technical contradiction, and such embodiments are also included in the present invention. In addition, the configurations shown in the above-described embodiments and the drawings, particularly the numerical values, do not limit the present invention, and configurations in which known elements are added or omitted are also included in the present invention.

### Explanation of References

10: superconducting coil device
20: MRI apparatus
30: display
100: coil unit
101: superconducting coil device
102: vacuum container
104: cryocooler
105: excitation power supply
200, 200A: processor
210: imaging controller
220: temperature management/alarm unit
230: magnet control unit
260: storage unit
400: remote system

## Claims

1. A helium-saving superconducting coil device comprising:
a superconducting coil housed in a container;
at least one cryocooler that is thermally connected to the superconducting coil and cools the superconducting coil; and
a processor that inputs temperature information of the superconducting coil detected by a temperature sensor installed in the container and issues a notification to a user,
wherein the processor stores a temperature equal to or lower than an excitation-allowable temperature at which excitation of the superconducting coil is allowable as an excitation warning temperature, and issues first notification information in a case in which a temperature of the superconducting coil detected by the temperature sensor exceeds the excitation warning temperature for a predetermined time or longer.

2. The superconducting coil device according to claim 1,
wherein the excitation-allowable temperature is a temperature obtained by subtracting a temperature rise amount due to heat generation during excitation of the superconducting coil from a critical temperature of the superconducting coil, and the processor stores a temperature lower than the excitation-allowable temperature as the excitation warning temperature.

3. The superconducting coil device according to claim 1 or 2,
wherein the first notification information issued by the processor is information notifying of a decrease in cooling performance of the cryocooler.

4. The superconducting coil device according to any one of the preceding claims,
wherein the processor
stores a second warning temperature different from the excitation warning temperature, and
issues second notification information different from the first notification information, in a case in which the temperature of the superconducting coil detected by the temperature sensor exceeds the second warning temperature for a predetermined time or longer.

5. The superconducting coil device according to claim 4,
wherein the second warning temperature stored in the processor is a temperature higher than the excitation warning temperature, and
the processor issues, as the second notification information, information notifying of urgency of replacement of the cryocooler.

6. The superconducting coil device according to claim 4 or 5,
wherein the superconducting coil is a static magnetic field generation coil for a magnetic resonance imaging apparatus,
the second warning temperature stored in the processor is an imaging warning temperature higher than the excitation warning temperature, and
the processor issues, as the second notification information, information related to continuation or change of imaging by the magnetic resonance imaging apparatus.

7. The superconducting coil device according to claim 6,
wherein the processor issues, as the second notification information, a proposal to change an imaging parameter of the imaging executed by the magnetic resonance imaging apparatus.

8. The superconducting coil device according to claim 6 or 7,
wherein the processor issues, as the second notification information, that the temperature of the superconducting coil is the imaging warning temperature before the imaging by the magnetic resonance imaging apparatus is started.

9. The superconducting coil device according to any one of claims 6 to 8,
wherein, before the imaging by the magnetic resonance imaging apparatus is started, the processor estimates a temperature rise of the superconducting coil caused by the imaging executed by the magnetic resonance imaging apparatus, and issues, as the second notification information, a warning based on estimated temperature information.

10. The superconducting coil device according to any one of the preceding claims,
wherein the processor controls an operation of an excitation power supply, in a case in which the temperature of the superconducting coil exceeds the excitation warning temperature for a predetermined time or longer.

11. The superconducting coil device according to any one of the preceding claims ,
wherein the processor issues the first notification information before excitation of the superconducting coil, in a case in which the temperature of the superconducting coil exceeds the excitation warning temperature.

12. A magnetic resonance imaging apparatus comprising:
a static magnetic field generation magnet; and
an imaging unit that causes nuclear magnetic resonance in atomic nuclei included in a subject placed in a static magnetic field space generated by the static magnetic field generation magnet to acquire an NMR signal,
wherein the static magnetic field generation magnet is the superconducting coil device according to claim 1.

13. The magnetic resonance imaging apparatus according to claim 12,
wherein the processor issues information related to whether to continue imaging executed by the imaging unit or change a condition for the imaging, in a case in which the temperature of the superconducting coil detected by the temperature sensor is a predetermined temperature higher than the excitation warning temperature.

14. A method of managing a temperature of a helium-saving superconducting coil device and issuing notification information corresponding to the temperature, the method comprising:
setting, as a temperature for managing the superconducting coil, an excitation warning temperature based on a critical temperature of the superconducting coil and a temperature rise due to heat generation during excitation; and
issuing notification information on a replacement time of a cryocooler that cools the superconducting coil, in a case in which a temperature of the superconducting coil detected by a temperature sensor exceeds the excitation warning temperature.

15. The method according to claim 14, the method further comprising:
setting, as a temperature for managing the superconducting coil, a plurality of warning temperatures including a first warning temperature as the excitation warning temperature and a second warning temperature higher than the first warning temperature; and
issuing different alarms in a case in which the temperature of the superconducting coil detected by the temperature sensor exceeds the first warning temperature and in a case in which the temperature exceeds the second warning temperature.
